# EUROPÄISCHE PATENTSCHRIFT

(11) **EP 2 577 761 B1**
(45) Veröffentlichungstag und Bekanntmachung des Hinweises auf die Patenterteilung: **11.09.2013**
(21) Anmeldenummer: 11726732.8
(22) Anmeldetag: 26.05.2011
(51) Int. Cl.: H01L 41/47, C30B 11/00, C30B 29/52

(54) **VERFAHREN ZUR HERSTELLUNG EINES EINKRISTALLINEN KÖRPERS AUS EINER MAGNETISCHEN FORMGEDÄCHTNIS-LEGIERUNG**
METHOD OF FABRICATING A SINGLE-CRYSTAL BODY FORMED OF A MAGNETIC SHAPE MEMORY ALLOY
PROCÉDÉ DE PRODUCTION D'UN CORPS MONOCRISTALLIN À PARTIR D'UN ALLIAGE À MÉMOIRE DE FORME MAGNÉTIQUE

(30) Priorität: 28.05.2010 DE 102010021856
(43) Veröffentlichungstag der Anmeldung: 10.04.2013
(73) Patentinhaber: Eto Magnetic GmbH, 78333 Stockach (DE)
(72) Erfinder: LAUFENBERG, Markus, 78333 Stockach (DE); PAGOUNIS, Emmanouel, 78315 Radolfzell (DE); DREVERMANN, Anne, 52064 Aachen (DE); STURZ, Laszlo, NL-6291 BG Vaals (NL)
(74) Vertreter: Behrmann, Niels
(86) Internationale Anmeldenummer: PCT/EP2011/058695
(87) Internationale Veröffentlichungsnummer: WO 2011/147946

(56) Entgegenhaltungen:
- GB-A- 2 330 099
- US-A- 5 062 469
- ZHU M ET AL: "Preparation of single crystal CuAlNiBe SMA and its performances", JOURNAL OF ALLOYS AND COMPOUNDS, ELSEVIER SEQUOIA, LAUSANNE, CH, Bd. 478, Nr. 1-2, 10. Juni 2009 (2009-06-10), Seiten 404-410, XP026095403, ISSN: 0925-8388, DOI: 10.1016/J.JALLCOM.2008.11.051
- ESAKA H ET AL: "Analysis of single crystal casting process taking into account the shape of pigtail", MATERIALS SCIENCE AND ENGINEERING A: STRUCTURAL MATERIALS:PROPERTIES, MICROSTRUCTURE & PROCESSING, LAUSANNE, CH, Bd. 413-414, 15. Dezember 2005 (2005-12-15), Seiten 151-155, XP026991504, ISSN: 0921-5093
- LI C ET AL: "Preparation of Single Crystal of TiNi Alloy and its Shape Memory Performance", PROC. OF SPIE,, Bd. 7493, 25. Juli 2009 (2009-07-25), Seiten 74931L1-74931L8, XP040502962,
- ROLFS K ET AL: "Double twinning in NiMnGaCo", ACTA MATERIALIA, ELSEVIER, OXFORD, GB, Bd. 58, Nr. 7, 1. April 2010 (2010-04-01), Seiten 2646-2651, XP026926874, ISSN: 1359-6454, DOI: 10.1016/J.ACTAMAT.2009.12.051
- LANDA M ET AL: "Ultrasonic characterization of Cu-Al-Ni single crystals lattice stability in the vicinity of the phase transition", ULTRASONICS, IPC SCIENCE AND TECHNOLOGY PRESS LTD. GUILDFORD, GB, Bd. 42, Nr. 1-9, 1. April 2004 (2004-04-01), Seiten 519-526, XP027331401, ISSN: 0041-624X
- XIONG F ET AL: "Fracture mechanism of a Ni-Mn-Ga ferromagnetic shape memory alloy single crystal", JOURNAL OF MAGNETISM AND MAGNETIC MATERIALS, ELSEVIER SCIENCE PUBLISHERS, AMSTERDAM, NL, Bd. 285, Nr. 3, 1. Januar 2005 (2005-01-01), Seiten 410-416, XP004669405, ISSN: 0304-8853, DOI: 10.1016/J.JMMM.2004.08.011

## Beschreibung

Die vorliegende Erfindung betrifft ein Verfahren zur Herstellung eines Einkristall-MSM-Körpers zur Herstellung eines MSM-Aktors.

MSM-Aktoren (auch "MSM-Aktuatoren" genannt) sind aus dem Stand der Technik allgemein bekannt und nutzen den Effekt aus, dass unter Einfluss eines Magnetfeldes sogenannte magnetische Formgedächtnismaterialien (MSM=Magnetic Shape Memory) eine Expansionsbewegung durchführen, welche - typischerweise im einstelligen Prozentbereich bezogen auf eine Länge eines jeweiligen Körpers entlang der Expansionsrichtung liegend - Grundlage für einen Antrieb sein kann und insoweit etwa eine Alternative zu bekannten, mittels Permanent- und/oder Elektromagneten realisierten Stellgliedern sein kann.

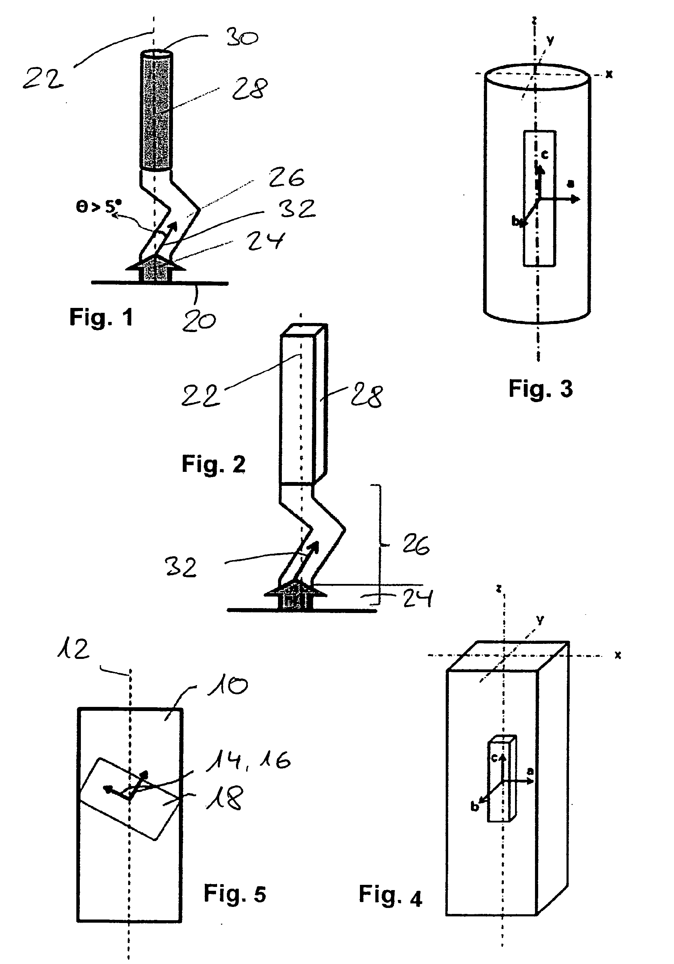

Entscheidend für die Wirksamkeit eines derartigen MSM-Aktors bzw. MSM-Aktorelements ist, neben der verwendeten Legierung (typischerweise eine Legierung auf der Basis von NiMnGa), die Kristallorientierung, in welcher das MSM-Element vorliegt: Als aus dem Stand der Technik bekannt vorauszusetzende Verfahren zur Herstellung von monokristallinem MSM-Material besitzen die Eigenschaft, dass sich eine durch Einbringen eines geschmolzenen Legierungsmaterials in eine Formschale und nachfolgendes Erkalten bzw. Erstarren des Legierungsmaterials ergebende Kristallorientierungen stochastisch ist, mit dem Ergebnis, dass eine Ausrichtung der Kristallachsen nicht vorbestimmbar ist und dann durch nachfolgende Fertigungsschritte des MSM-Körpers herausgebildet werden muss. Eine derartige Anordnung zeigt die Fig. 5 zum Stand der Technik: Ein in der vorbeschriebenen Weise erstarrter und langgestreckter MSM-Einkristall 10 weist eine durch die Formschale bestimmte geometrische Längsachse 12 auf. Weitgehend stochastisch während des Erstarrens des Materials hat sich jedoch eine Kristallorientierung im Einkristall 10 gebildet, welche beispielhaft durch eine erste Kristallachse 14 und eine zweite, dazu orthogonale Kristallachse 16 (wobei die dritte Achse dann automatisch zu beiden orthogonal festliegt) beschrieben wird. Dies führt dann dazu, dass aus dem gefertigten Einkristall ein MSM-Element 18 (nach vorherigem Ermitteln der Kristallachsen durch Vermessen) herausgeschnitten werden kann, welches eine durch die gezeigten geometrischen Verhältnisse begrenzte Maximalabmessung aufweist (mit entsprechend viel Verschnitt). Dies führt in der Konsequenz dazu, dass bei gängigen Längsabmessungen von monokristallinen MSM-Elementen im Bereich zwischen 10 mm und 30 mm und gewünschten Querschnitten von typischerweise zwischen 5 mm² und 30 mm² entsprechend große Einkristalle 10 (Fig. 5) produziert werden müssen, um auch für den Fall ungünstiger Kristallorientierungen die gewünschten Mindestabmessungen für das MSM-Element fertigen zu können. Offensichtlich ist, dass diese als bekannt vorauszusetzende Vorgehensweise in mehrfacher Hinsicht ineffizient ist; zum einen entsteht in beträchtlichem Umfange Verschnitt durch die notwendigen Schneidevorgänge (typischerweise durchgeführt durch Drahterodieren), zum anderen ist in jedem Fall eine Vermessung des erzeugten Einkristalls im Hinblick auf eine Ermittlung der Kristallorientierung notwendig (typisches Vorgehen durch Röntgendiffraktometrie), um überhaupt die Voraussetzung für das nachfolgende Schneiden zu schaffen.

Auch ergibt sich aus der beispielhaften Betrachtung der geometrischen Verhältnisse der Fig. 5, dass die maximal erreichbaren Abmessungen (z.B. eine Längserstreckung eines herzustellenden MSM-Elements) begrenzt sind.

Aus dem Stand der Technik ist es bekannt, dass sogenannte Ankeimkristalle (Seed Crystals) eine Kristallorientierung bei einem Einkristall-Herstellungsprozess beeinflussen können. Im Wesentlichen wird zu diesem Zweck ein geeigneter und in der gewünschten Weise orientierter Einkristall zu Prozessbeginn in den Prozess einbezogen, auf dem sich der herzustellende Kristall idealerweise monokristallin ankeimt. Allerdings ist diese Vorgehensweise auch in mehrfacher Hinsicht problematisch; nicht nur sind geeignete Ankeimkristalle kostenträchtig und insbesondere für industrielle Fertigungsprozesse außerhalb einer Laborumgebung schwierig zu handhaben, auch erfordern derartige Ankeimkristalle eine sehr präzise Prozessführung, um das korrekte Ankeimverhalten zu erreichen (mit weiteren möglichen Nachteilen auf den MSM-Effekt eines erzeugten MSM-Elements, falls der Ankeimkristall legierungsfremdes Material aufweist). Damit besteht, neben dem offensichtlichen Bedarf nach Effizienzsteigerung gemäß vorbeschriebener Problemstellung, auch der Bedarf nach prozesstechnischer Vereinfachung, mit dem Ziel, einfach zu handhabende und potentiell großtechnische Prozesse zur Herstellung von Einkristall-MSM-Körpern zu ermögüchen.

Zum weiteren Stand der Technik wird auf die folgende Dokumente verwiesen:
1. M. ZHU et al.: "Preparation of single crystal CuAlNiBe SMA and ist performances", JOURNAL OF ALLOYS AND COMPOUNDS, Bd. 478, Nr. 1-2, 10. Juni 2009, Seite 404-410;
2. H. ESAKA et al.: "Analysis of single crystal casting process taking into account the shape of pigtail", MATERIALS SCIENCE AND ENGINEERING A, Bd. 413-414, 15. Dezember 2005, Seiten 151-155;
3. GB 2 330 099 A;
4. C. LI et al.: "Preparation of Single Crystal of TiNi Alloy and its Shape Memory Performance", PROC. OF SPIE, Bd. 7493, 2009, Seiten 7493L1-74931 L8;
5. K. ROLFS et al.: "Double twinning in NiMnGaCo", ACTA MATERIALIA, Bd. 58, Nr. 7, 1. April 2010, Seiten 2646-2651;
6. US 5 062 469 A;
7. M. LANDA et al.: "Ultrasonic characterization of Cu-Al-Ni single crystals lattice stability in the vicinity of the phase transition", ULTRASONICS, Bd. 42, Nr. 1-9, 1. April 2004, Seiten 519-526;
8. F. XIONG et al.: "Fracture mechanism of a Ni-Mn-Ga ferromagnetic shape memory alloy single crystal" JOURNAL OF MAGNETISM and MAGNETIC MATERIALS, Bd. 285, Nr. 3, 1. Januar 2005, Seiten 410-416.

Aufgabe der vorliegenden Erfindung ist es daher, ein Verfahren zur Herstellung eines Einkristall-MSM-Körpers zu schaffen, das im Hinblick auf Materialausnutzung und Effizienz des zugehörigen Einkristall-Materials verbessert ist, insbesondere Verschnitt des Einkristall-Materials zum Herstellen eines oder mehrerer MSM-Elemente aus dem monokristallinen MSM-Körper reduziert und zusätzlich die Notwendigkeit eines Ankeimkristalls unnötig macht.

Die Aufgabe wird durch das Verfahren mit den Merkmalen des Hauptanspruchs gelöst; vorteilhafte Weiterbildungen der Erfindung sind in den Unteransprüchen beschrieben. Zusätzlicher Schutz im Rahmen der vorliegenden Erfindung wird beansprucht für einen Einkristall-MSM-Körper, (bevorzugt zur Nutzung als Aktor bzw. Aktorelement), welcher durch das Verfahren nach dem Hauptanspruch sowie der davon abhängigen Patentansprüche hergestellt ist. Dabei wird davon ausgegangen, dass der aus dem beanspruchten Verfahren resultierende (und weiter in einzelne Aktorelemente) zerteilte Körper noch mit typischen (und ansonsten bekannten) Wärmebehandlungs- und/oder magnetomechanischen Trainingsschritten behandelt wird, um das magnetische Formgedächnisverhalten zu erreichen bzw zu optimieren. Dabei ist es insbesondere weiterbildungsgemäß von der Erfindung umfasst, einzelne oder die Mehrzahl von MSM-Aktorelementen nach dem Zerteilen einer Wärmebehandlung zu unterziehen, um das magnetische Formgedächtnisverhalten zu stimulieren; alternativ kann diese Wärmebehandlung auch am verfestigten MSM-Legierungsmaterial vor dem Zerteilen in die Mehrzahl von MSM-Aktorelemente erfolgen. Auch ist es im Rahmen bevorzugter Weiterbildungen der Erfindung vorgesehen, die vereinzelten (verteilten) MSM-Aktorelemente in der Art eines Trainings gezielt und vorbestimmt zu bewegen, um
das Formgedächnisverhalten zu stimulieren. Hier ist es insbesondere vorgesehen (und ansonsten auch als bekannt vorausgesetzt), dass ein vereinzeltes Element in der vorgesehenen Expansionsrichtung gezielt bewegt wird, etwa durch das Aufbringen von Zug- und/oder Druckkräften, um so mit Hilfe derartiger mechanischer Hübe das Training durchzuführen.

In erfindungsgemäß vorteilhafter Weise erfolgt die Herstellung des Einkristall-MSM-Körpers - bevorzugt auf der Basis eines NiMnGaX-Legierungsmaterials, wobei X fakultativ ein oder mehrere Elemente aus der Gruppe Co, Fe und Cu aufweist - ohne die Notwendigkeit, einen (gesonderten) Ankeimkristall vorzusehen, vielmehr allein aus dem Einbringen des aufgeschmolzenen MSM-Legierungsmaterials in die erfindungsgemäß besonders ausgestaltete Formschale. Genauer gesagt weist diese eine Längsachse auf und ist im Bereich des Selektorbereichs von dieser Längsachse ausgelenkt, erfindungsgemäß um eine Auslenkung, die über die maximale querschnittliche Breite im Selektorbereich hinausgeht. Damit ist es im Rahmen der Erfindung vorgesehen, eine längsschnittliche Geometrie des erfindungsgemäß durch Ausbildung des Selektorbereichs auslenkenden Erstarrungspfades so zu realisieren, dass diese Auslenkung in Querschnittsrichtung größer ist als eine maximale Querschnittsweite im Selektorbereich, mit anderen Worten, der Bereich der maximalen Auslenkung liegt außerhalb einer Projektion des Querschnitts im Kristallbereich auf den Eingang des Selektorbereichs entlang der Längsachse.

Weiterbildungsgemäß besitzt diese Auslenkung längsschnittlich die Form mindestens eines Zackens, alternativ einer Wendel, einer Helix oder einer anderen Winkelgestaltung.

Durch diese vorteilhafte Maßnahme erfährt dann in erfindungsgemäßer Weise die Kristallstruktur des erstarrenden bzw. dann erstarrten MSM-Materials eine Kristallorientierung, welche sich an der Längsachse orientiert, genauer gesagt entlang der Richtung der Längsachse der Formschale verläuft (bzw. von dieser um eine Winkelabweichung abweicht, welche erfindungsgemäß < 10° beträgt, weiterbildungsgemäß vorteilhaft < 6° beträgt, noch weiterbildungsgemäß und vorteilhaft weniger als 3° beträgt).

Damit wird dann durch die vorliegende Erfindung vorteilhaft erreicht, dass (mit diesem in der praktischen Realisierung dann vernachlässigbaren Orientierungsfehler) ein Einkristall erzeugt wird, dessen Kristallorientierung nicht mehr stochastisch entsteht, sondern geprägt wird durch die mechanische Ausrichtung der Formschale entlang der Längsachse (bzw. des erfindungsgemäß ausgelenkt ausgebildeten Verlaufabschnitts für die Erstarrung im Selektorbereich). Die sich daraus ergebende vorteilhafte Konsequenz für die Serienfertigung ist evident: Nicht nur wird der bei einer Nachbearbeitung bzw. dem Aufteilen des erstarrten Materials in eine Mehrzahl von MSM-Elementen notwendige Verschnitt drastisch reduziert, auch liegt durch das erfindungsgemäße Vorgehen zumindest die Kristallorientierung im Hinblick auf die Längsachse fest, mit anderen Worten, vor einer allfälligen Nachbearbeitung des Einkristalls zur Realisierung des/r MSM-Elemente(s) würde sich ein aufwendiger Schritt der Orientierungsmessung (etwa mittels Röntgendiffraktometrie) erübrigen.

Wird dann, wie vorteilhaft und weiterbildungsgemäß vorgesehen, auch die Formschale (insbesondere im Selektor- bzw. Kristallbereich) querschnittlich rechteckig ausgestaltet, lässt sich zusätzlich die Kristallorientierung des erstarrenden bzw. erstarrten MSM-Materials entlang einer zweiten orthogonal zur ersten Kristallachse verlaufenden Kristallachse (und damit automatisch der dritten orthogonalen Achse) beeinflussen, so dass im Ergebnis auf diese Weise dann auch die vollständige dreidimensionale Kristallorientierung eines resultierenden Kristalls im Raum determiniert wird (wiederum ohne die Notwendigkeit einer Vermessung).

Im Rahmen der praktischen Realisierung der Erfindung ist es besonders günstig und bevorzugt, die Längsachse in vertikaler Richtung vorzusehen, damit diese etwa senkrecht zu einer (ansonsten bekannten) Kaltplatte als Kühlvorrichtung im bzw. am Ankeimbereich der Formschale vorzusehen. Wird dann die Formschale (in ansonsten bekannter Weise) aus einem Wärme- bzw. Heizumfeld, entgegengesetzt der Längsachse, mit einer Ziehgeschwindigkeit bewegt, erstarrt in diese Formschale in flüssigem Zustand eingebrachtes Legierungsmaterial aufgrund des Temperaturgradienten dann in Aufwärtsrichtung entlang eines Erstarrungspfades, welcher durch die Längsachse beschreibbar ist und, von dieser abweichend, erfindungsgemäß im Selektorbereich ausgelenkt wird. Weiterbildungsgemäß vorteilhaft ist dabei das Erstarrungs- bzw. Abkühlungsverhalten der Formschale so eingerichtet, dass querschnittlich (radial) kein signifikanter Temperaturgradient von innen nach außen in der Schmelze benachbart der Erstarrungsfront vorhanden ist, und ein Temperaturgradient der Schmelze nahe der Erstarrungsfront auf Werte zwischen 0,3 K/mm und 20 K/mm eingestellt wird, wobei ein besonders bevorzugter Wertebereich zum Erzeugen der gewünschten Kristallorientierung im Bereich zwischen 1 K/mm und 15 K/mm liegt. Ergänzend oder alternativ ist es weiterbildungsgemäß günstig, die Abkühlungsgeschwindigkeit, beschrieben durch die Bewegungsgeschwindigkeit der Erstarrungsfront entlang des Erstarrungspfades (bzw. eine Ziehgeschwindigkeit der Formschale relativ zum Temperaturgradienten), auf einen Bereich zwischen 0,1 mm/min und 10 mm/min einzurichten, wobei ein besonders bevorzugter Bereich zwischen 0,3 mm/min und 5 mm/min liegt.

Auf diese Weise wird dann vorteilhaft ein monokristallines Erstarrungsverhalten erreicht, welches zumindest entlang der Längsachse die erste Kristallachse der Kristallstruktur ausbildet (bzw. zwischen diesen Achsen eine maximale Winkelabweichung von weniger als 10°, typischerweise von weniger als 6° oder gar weniger als 3° zeigt). Für den Fall, dass weiterbildungsgemäß vorteilhaft auch der Querschnitt von Selektorbereich und/oder Kristallbereich (d.h. die Ebene senkrecht zur Längsachse) rechteckförmig, weiter bevorzugt quadratisch, ausgestaltet ist, lässt sich zusätzlich eine Beeinflussung (Vorgabe) der orthogonalen zweiten bzw. dritten Kristallachse, in der Richtung der rechteckigen Längskanten im Querschnitt, erreichen, so dass im Idealfall eines z.B. langgestreckten und querschnittlich rechteckförmigen Kristallbereichs der Formschale dieser Bereich die dreidimensionale Orientierung eines darin erstarrten Einkristalls vorgibt. Dabei ist im Rahmen der Erfindung vorgesehen, ein auf das Erstarren folgendes Zerteilen (stets) senkrecht zur Längsachse (Z-Achse) durchzuführen, da ja insoweit, mit den vorbeschriebenen maximalen Abweichungen, die Kristallorientierung bereits feststeht.

Im Ergebnis ermöglicht damit die vorliegende Erfindung nicht nur eine drastische Verminderung von Herstellungs- bzw. vorgelagerten Prüfschritten (da idealerweise auf jegliches Vermessen der Kristallorientierung verzichtet werden kann), auch gestattet es die Erfindung, aus dem beschränkten Innenraum einer Formschale dimensionsmäßig optimierte MSM-Elemente zu erzeugen, da insbesondere bereits bei dem beschriebenen Formungsvorgang durch Erstarren entlang einer der Längsachse der Formschale entsprechenden Erstarrungsrichtung und einer damit bewirkten Kristallausrichtung eine maximale Längendimension produzierbar wird. Dann steht insbesondere zu erwarten, dass effizient und mit geringem Herstellungsaufwand (und damit potenziell großtechnisch) MSM-Elemente als Grundlage für das Herstellen von MSM-Aktoren produziert werden können (auch durch weiteres Zerteilen, z.B. Zersägen), welche Längenabmessungen von mehr als 20 mm insbesondere mehr als 40 mm erreichen und/oder eine Querschnittsfläche von 15 mm² oder mehr gestatten.

Weitere Vorteile, Merkmale und Einzelheiten der Erfindung ergeben sich aus der nachfolgenden Beschreibung bevorzugter Ausführungsbeispiele sowie anhand der Figuren; diese zeigen in:
- Fig. 1: eine geometrische Prinzipdarstellung einer Formschalenanordnung zur Durchführung des Verfahrens gemäß einem ersten Ausführungsbeispiel der Erfindung;
- Fig. 2: eine Darstellung analog Fig. 1, jedoch mit einer anderen geometrischen Ausgestaltung in Form eines querschnittlich rechteckigen Kristallbereichs der Formschale;
- Fig. 3: eine Schemadarstellung eines zylindrischen MSM-Einkristalls und einer darin schematisch eingezeichneten Kristallorientierung bei Realisierung der Erfindung;
- Fig. 4: eine Darstellung analog Fig. 3, jedoch mit einem quaderförmigen Einkristall-Körper zur Verdeutlichung der Kristallorientierung eines darin schematisch vorgesehenen (ebenfalls quaderförmigen) MSM-Aktorelements und
- Fig. 5: eine schematische Darstellung eines nach einem generischen Verfahren aus dem Stand der Technik realisierten MSM-Einkristalls mit darin stochastisch orientierten Kristallachsen sowie den sich daraus ergebenden beschränkten Schnittmöglichkeiten für ein MSM-Aktorelement.

Die Fig. 1 verdeutlicht das Prinzip, mit welchem die vorliegende Erfindung entsprechend einem ersten Ausführungsbeispiel realisiert werden kann. Gezeigt ist eine sogenannte Formschale zum Erzeugen von monokristallinen Körpern nach dem sogenannten Bridgman-Verfahren, welche, sich von einer Kaltplatte 20 senkrecht entlang einer Längsachse (Strichpunktlinie 22) erstreckend, einen Ankeimbereich 24, darauffolgend einen Selektorbereich 26 sowie einen Kristallbereich 28 ausbildet. Geeignet aufgeschmolzenes Legierungsmaterial wird durch eine obere Öffnung 30 in die Vorrichtung eingebracht, und das flüssige Legierungsmaterial erstarrt dann von unten nach oben (Pfeilrichtung 32) unter Ausbildung einer sich entsprechend aufwärts bewegenden Erstarrungsfront, deren Bewegungsgeschwindigkeit durch geeignete Temperaturbeeinflussung vorbestimmt ist.

Die Fig. 1 (wie auch die analoge Fig. 2) verdeutlichen, wie erfindungsgemäß der Erstarrungspfad nicht senkrecht und linear entlang der Längsachse 22 erfolgt, sondern vielmehr einen aus der Fig. 1 bzw. der Fig. 2 längsschnittlich geknickten Linienverlauf aufweist; genauer gesagt ist im Selektorbereich 26 die Formschale so ausgestaltet, dass deren für das Erstarren wirksamer Innenkanal (aus der Richtung von unten nach oben) zunächst um einen Winkel ϕ von ca. 40° ausgelenkt ist und dann einen weiteren, jedoch entgegengesetzt ausgelenkten Abschnitt aufweist, bis der Kanal am oberen Ende des Selektorbereichs wiederum querschnittlich mit dem bodenseitigen Querschnitt fluchtet. Erfindungsgemäß vorteilhaft sorgt diese Auslenkung, welche im dargestellten Ausführungsbeispiel an ihrer maximalen seitlichen Auslenkung über die Projektion des Querschnitts im Kristallbereich bzw. im Bodenbereich benachbart der Kaltplatte 20 hinausgeht, in vorteilhafter Weise für eine Längsorientierung der Kristallstrukturen in Vertikalrichtung, d.h. der Richtung der Achse 22. Dies führt dann dazu, dass im erstarrten Zustand im Bereich des Kristallbereichs 28 der dort vorhandene Einkristall eine Orientierung aufweist, welche zumindest eine erste Kristallachse orientiert in der Richtung der Längsachse aufweist (wobei hier erfindungsgemäß ein maximaler Winkelfehler von 10°, typischerweise jedoch von weniger als 6° oder gar weniger als 3°, erreicht werden kann).

Die Fig. 2 zeigt eine Variante des Ausführungsbeispiels der Fig. 1; hier ist im Kristallbereich 28' der sich vertikal entlang der Längsachse 22 erstreckende Kanal im Querschnitt quadratisch, so dass sich, neben einer Kristallachsenorientierung in Vertikalrichtung, zusätzlich die beiden dazu orthogonalen Kristallachsen parallel zu den Kantenverläufen des Kristallbereichs erstrecken. Diese geometrischen Verhältnisse verdeutlichen die Fig. 3 bzw. 4, insoweit entsprechend den Realisierungsformen von Fig. 1 bzw. Fig. 2: Fig. 3 zeigt das Ergebnis eines in einem hohlzylindrischen Kristallbereich erstarrten Einkristallkörpers. Die Richtung der Längsachse (hier: z-Achse) entspricht annähernd der Ausrichtung der Kristall-Längsachse c mit dem beschriebenen kleinen möglichen Winkelfehler. Aufgrund der Zylinderstruktur (d.h. Kreisform in der x-y-Ebene in Fig. 3) sind die zwei weiteren, zueinander sowie zur Vertikalachse c orthogonalen Achsen in ihrer Ausrichtung stochastisch. Dagegen bietet die Weiterbildung der Fig. 2 (Geometrie gemäß Fig. 4) die Möglichkeit, durch Vorsehen der quadratischen Querschnittskontur (hier verlaufend parallel zur x- bzw. y-Richtung) entsprechend parallel die zweite (a) bzw. dritte (b) Kristallachse auszuprägen, so dass als Ergebnis der in Fig. 2 bzw. Fig. 4 beschriebenen Durchführung des Verfahrens ein Einkristall erreicht wird, welcher durch seine Quaderform bereits weitestgehend auch seine tatsächliche kristalline Orientierung beschreibt und insoweit potentiell nicht (oder nur minimal) nachbearbeitungsbedürftig ist. Auch ist das Ergebnis des Herstellungsverfahrens gemäß Fig. 1 (Fig. 3) insoweit bereits vorteilhaft, als hier mit der Kristallachse (c), verlaufend in der Richtung der Längserstreckung (z) der Formschale sowie des darin erstarrten Rohlings, eine etwa für das Expansionsverhalten eines MSM-Körpers maßgebliche Ausrichtung festliegt und auch ein solcher zylindrischer Körper dann ohne weitere (oder lediglich mit minimaler) Nachbearbeitung benutzbar ist, wenn es auf die genaue Ausrichtung der a- bzw. b-Kristallachsen nicht ankommt.

Im Weiteren wird anhand eines konkreten Beispiels die Durchführung des Verfahrens beschrieben:

Legierungs-Ausgangsmaterial wird als sogenannte Masterlegierung durch Induktionsschmelzen aus den Materialien NiMnGa, entsprechend der Zusammensetzung für eine MSM-Legierung, durch Induktionsschmelzen hergestellt. Eine typische Schmelztemperatur wird auf einen Bereich zwischen 50° und 400° oberhalb der Verflüssigungstemperatur der jeweiligen Legierung eingestellt. Typischerweise findet das Aufschmelzen unter einer Ar-Atmosphäre zwischen 100 mbar und 1200 mbar statt.

Die flüssige Masterlegierung wird in eine keramische Formschale gegossen, welche eine Geometrie entsprechend der Fig. 1 aufweist. Diese Formschale wird im Bridgman-Verfahren relativ zu einem Temperaturgradienten aus einer heißen Zone in eine kalte Zone bewegt, so dass die Erstarrungsfront die Formschale von unten nach oben durchläuft. Diese Geschwindigkeit der Bewegung der Erstarrungsfront liegt typischerweise bei 0,3 mm/min; der Temperaturgradient in der Schmelze nahe der Erstarrungsfront wird auf einen Wert von typischerweise 3 K/mm eingestellt. Nach Durchlaufen des gemäß der Erfindung vorteilhaft ausgelenkten Selektorbereichs erstarrt das MSM-Material mit einer vertikal, d.h. entlang der Richtung der Längsachse 22 ausgerichteten Kristallachse, so dass nach abschließendem Erstarren und Erkalten dem Kristallbereich 28 ein Zylinder als MSM-Körper der in Fig. 3 gezeigten Geometrie entnommen werden kann. Dieser bietet nunmehr die Möglichkeit, unmittelbar einen MSM-Aktuator mit sich axial erstreckender Bewegungs-(Expansions-)richtung zu realisieren, alternativ lässt sich aus diesem Körper durch Bestimmen einer kristallinen Querachse die Voraussetzung dafür schaffen, dass mit wenig Verschnitt und minimierter mantelseitiger Abtragung ein oder mehrere querschnittlich rechteckige(r) bzw. quaderförmige(r) MSM-Elemente mit auch in Querrichtung definierter Kristallorientierung geschaffen werden können. Für ein solches Vereinzeln bieten sich insbesondere Schnitte senkrecht zur Z-Achse an, da ja insoweit die Orientierung bereits ausgeprägt ist.

Zur Stimulierung bzw. Realisierung einer vollständigen Formgedächtnis-Funktionalität von auf die beschriebene Weise realisierten Aktuatoren wird das Material wärmebehandelt (entweder als Gesamtkörper vor dem Zertrennen, alternativ durch Wärmebehandeln der zerteilten Einzel-Aktuatorelemente). Auch ist es vorteilhaft, diese Elemente nach dem Zerteilen in ihrem Bewegungs- bzw. Expansionsverhalten zu trainieren, wobei zu diesem Zweck, typischerweise über einige Hübe, in der vorgesehenen Expansions- bzw. Bewegungsrichtung durch entsprechenden Zug- bzw. Druckkrafteintrag eine Bewegung in das Material eingeprägt wird.

Während die vorbeschriebene Anordnung und deren Betrieb zur Realisierung des erfindungsgemäßen Verfahrens generisch und prinzipiell zu verstehen sind (und durch den Fachmann geeignet ausgestaltet und angepasst werden), liegt es insbesondere auch im Rahmen der vorliegenden Erfindung, in der Art einer mehrarmigen Formschale eine Mehrzahl von Erstarrungspfaden entlang jeweils voneinander getrennten, gleichwohl benachbarten Selektor- und Kristallbereichen vorzusehen.

Die Einsatzbereiche eines MSM-Körpers, welcher durch die vorliegende Erfindung hergestellt wird, sind potentiell unbegrenzt; es steht vorteilhaft zu erwarten, dass die vorliegende Erfindung gleichwohl die großtechnische Herstellung derartiger, im Hinblick auf die Kristallgeometrie eindeutig bestimmter Körper erheblich vereinfacht und ökonomischer gestaltet, so dass zukünftig weitere Anwendungsgebiete für eine MSM-Aktorik erschlossen werden.

## Patentansprüche

1. Verfahren zur Herstellung eines eine determinierte Kristallorientierung entlang einer ersten Kristallachse aufweisenden MSM-Aktorelements aus einem Einkristall-MSM-Körper durch Einbringen eines aufgeschmolzenen Legierungsmaterials in eine Formschale und nachfolgendes Erstarren des Legierungsmaterials, mit den Schritten:
- Vorsehen einer einen Ankeimbereich (24), einen Selektorbereich (26) sowie einen Kristallbereich (28) aufweisenden, zumindest abschnittsweise entlang einer Längsachse (22) ausgerichteten Formschale,
- Einbringen des aufgeschmolzenen MSM-Legierungsmaterials, insbesondere NiMnGa-basierten Legierungsmaterials, in die Formschale, ohne dass ein gesonderter Ankeimkristall vorgesehen ist,
- Verfestigen des MSM-Legierungsmaterials durch Erzeugen einer sich vom Ankeimbereich über den Selektorbereich in den Kristallbereich entlang eines Erstarrungspfades bewegenden Erstarrungsfront,
wobei der Erstarrungspfad im Kristallbereich entlang der Längsachse verläuft, im Selektorbereich einen von der Längsachse ausgelenkten Bereich ausbildet, dessen maximale Auslenkung, bezogen auf die Längsachse, größer als eine maximale Querschnittsweite im Selektorbereich ist, und
die Längsachse (22) eine Winkelabweichung von weniger als 10°, bevorzugt weniger als 6°, weiter bevorzugt weniger als 3°, von der ersten Kristallachse aufweist, und
- Zerteilen des erstarrten MSM-Legierungsmaterials in eine Mehrzahl von MSM-Aktorelementen durch Schnitte senkrecht zu der Längsachse.

2. Verfahren nach Anspruch 1, **dadurch gekennzeichnet, dass** der Erstarrungspfad im Selektorbereich einen zackenartig mit zwei abgewinkelten Abschnitten ausgelenkten Bereich ausbildet, dessen Eingangs- und Ausgangsseite bevorzugt fluchtend zur Längsachse ausgerichtet ist.

3. Verfahren nach Anspruch 1, **dadurch gekennzeichnet, dass** der Erstarrungspfad im Selektorbereich einen helixförmigen oder zickzackförmigen Bereich ausbildet.

4. Verfahren nach einem der Ansprüche 1 bis 3, **dadurch gekennzeichnet, dass** die Längsachse vertikal zu einer dem Ankeimbereich zugeordneten planen Kühlvorrichtung, insbesondere Kaltplatte ausgerichtet ist.

5. Verfahren nach einem der Ansprüche 1 bis 4, **dadurch gekennzeichnet, dass** der sich langgestreckt entlang der Längsachse erstreckende Kristallbereich eine wirksame Querschnittsfläche für die Erstarrungsfront von > 3cm², insbesondere > 7cm², insbesondere auch größer 12cm² aufweist.

6. Verfahren nach einem der Ansprüche 1 bis 5, **dadurch gekennzeichnet, dass** das MSM-Legierungsmaterial zum Erzeugen der Erstarrungsfront so gekühlt wird, dass ein im Selektorbereich entstehender Temperaturgradient in der Schmelze, der Erstarrungsfront benachbart, zwischen 0,3 K/mm und 20 K/mm, insbesondere zwischen 1 K/mm und 15 K/mm, beträgt.

7. Verfahren nach einem der Ansprüche 1 bis 6, **dadurch gekennzeichnet, dass** das MSM-Legierungsmaterial zum Erzeugen der Erstarrungsfront so behandelt wird, insbesondere durch Bewirken einer Relativgeschwindigkeit zwischen der Formschale und dem Temperaturgradienten, dass die Erstarrungsfront im Selektorbereich sich mit einer Geschwindigkeit zwischen 0,1 mm/min und 50 mm/min, insbesondere zwischen 0,3 mm/min und 5 mm/min, entlang des Erstarrungspfades bewegt.

8. Verfahren nach einem der Ansprüche 1 bis 7, **dadurch gekennzeichnet, dass** sich die Erstarrungsfront entlang des Erstarrungspfades durch einen zumindest abschnittsweise querschnittlich rechteckigen, insbesondere quadratischen, Selektotbereich und/oder Kristallbereich bewegt.

9. Verfahren nach Anspruch 8, **dadurch gekennzeichnet, dass** eine querschnittlich rechteckige Innenkontur des Kristallbereichs eine Kristallorientierung des monokristallin erstarrten MSM-Legierungsmaterials in mindestens einer zweiten, zur ersten Kristallachse orthogonalen Kristallachse bestimmt.

10. Verfahren nach einem der Ansprüche 1 bis 9, **dadurch gekennzeichnet, dass** das Legierungsmaterial Ni, Mn, Ga sowie mindestens Co in der Zusammensetzung NiₐMn_{b}Ga_{c}CO_{d}FeₑCu_{f} aufweist, wobei a, b, c, d, e und f in Atom-% angegeben sind und die Bedingungen
44 ≤ a ≤ 51;
19 ≤ b ≤ 30;
18 ≤ c ≤ 24;
0,1 ≤ d ≤ 15;
0 ≤ e ≤ 14,9;
0 ≤ f ≤ 14,9;
d+e+f ≤ 15;
a+b+c+d+e+f = 100;
erfüllen.

11. Verfahren nach einem der Ansprüche 1 bis 10, **dadurch gekennzeichnet, dass** das Verfestigen des MSM-Legierungsmaterials entlang einer Mehrzahl von einander benachbarten und voneinander getrennten Erstarrungspfaden erfolgt.

12. Verfahren nach einem der Ansprüche 1 bis 11, **gekennzeichnet durch** das Teilen des im Kristallbereich erstarrten MSM-Legierungsmaterials in die Mehrzahl von MSM-Aktorelementen ohne vorheriges messtechnisches Ermitteln einer Kristallorientierung im erstarrten MSM-Legierungsmaterial.

## Claims

1. A process for producing an MSM actuator element with a determinate crystal orientation along a first crystal axis from a single-crystal MSM solid by introducing a molten alloying material into a mould and subsequently solidifying the alloying material, comprising the steps of:
- providing a mould which comprises a seeding zone (24), a selector zone (26) and a crystal zone (28) at least in sections along a longitudinal axis (22);
- introducing the molten MSM alloying material, in particular a NiMnGa-based alloying material, into the mould without providing a separate seed crystal;
- consolidating the MSM alloying material by generating a solidification front moving from the seeding zone across the selector zone into the crystal zone along a solidification track,
wherein the solidification track in the crystal zone runs along the longitudinal axis, forms a zone which is deflected from the longitudinal axis in the selector zone the maximum deflection of which, with respect to the longitudinal axis, is greater than a maximum cross-sectional width in the selector zone, and
wherein the longitudinal axis (22) has an angular deviation of less than 10°, preferably less than 6°, more preferably less than 3° from the first crystal axis; and
- splitting the solidified MSM alloying material into a plurality of MSM actuator elements by means of cuts perpendicular to the longitudinal axis.

2. The process as claimed in claim 1, **characterized in that** the solidification track in the selector zone forms a zone which is deflected in a serrated manner with two angled sections, the entry and exit sides of which preferably being aligned with the longitudinal axis.

3. The process as claimed in claim 1, **characterized in that** the solidification track in the selector zone forms a helical or zigzagged zone.

4. The process as claimed in one of claims 1 to 3, **characterized in that** the longitudinal axis is orientated vertically to a planar cooling device, in particular a cooling plate, associated with the seeding zone.

5. The process as claimed in one of claims 1 to 4, **characterized in that** the crystal zone extending in an elongated manner along the longitudinal axis has an effective cross-sectional area for the solidification front of > 3 cm², in particular > 7 cm², in particular more than 12 cm².

6. The process as claimed in one of claims 1 to 5, **characterized in that** the MSM alloying material for producing the solidification front is cooled such that a temperature gradient in the melt, occurring in the selector zone adjacent to the solidification front, is between 0.3 K/mm and 20 K/mm, in particular between 1 K/mm and 15 K/mm.

7. The process as claimed in one of claims 1 to 6, **characterized in that** the MSM alloying material for producing the solidification front is treated, in particular by producing a relative speed between the mould and the temperature gradient, such that the solidification front in the selector zone moves along the solidification track at a speed of between 0.1 mm/min and 50 mm/min, in particular between 0.3 mm/min and 5 mm/min.

8. The process as claimed in one of claims 1 to 7, **characterized in that** the solidification front moves along the solidification track through a selector zone and/or crystal zone which at least in sections is rectangular in cross-section, in particular square in cross-section.

9. The process as claimed in claim 8, **characterized in that** an inner contour of the crystal zone which is rectangular in cross-section determines a crystal orientation of the single crystal solidified MSM alloying material in at least a second crystal axis which is orthogonal to the first crystal axis.

10. The process as claimed in one of claims 1 to 9, **characterized in that** the alloying material comprises Ni, Mn, Ga and at least Co in the composition NiaMnbGacCodFeeCuf, wherein a, b, c, d, e and f are given as atomic percentages and satisfy the following conditions:
44 ≤ a ≤ 51;
19 ≤ b ≤ 30;
18 ≤ c ≤ 24;
0. 1 ≤ d ≤ 15;
0 ≤ e ≤ 14.9;
0 ≤ f ≤ 14.9;
d+e+f ≤ 15;
a+b+c+d+e+f = 100.

11. The process as claimed in one of claims 1 to 10, **characterized in that** consolidation of the MSM alloying material takes place along a plurality of solidification tracks which are adjacent to one another and separated from one another.

12. The process as claimed in one of claims 1 to 11, **characterized by** dividing the MSM alloying material which has solidified in the crystal zone into the plurality of MSM actuator elements without prior metrological identification of a crystal orientation in the solidified MSM alloying material.

## Revendications

1. Procédé de production d'un élément d'actionneur à mémoire de forme magnétique [MFM] présentant une orientation cristalline déterminée le long d'un premier axe de cristal à partir d'un corps mono-cristallin MFM par introduction d'un matériau d'alliage fondu dans une coquille de moulage et par solidification ultérieure du matériau d'alliage, comportant les étapes suivantes:
- prévoir une coquille de moulage présentant une zone de germination (24), une zone de sélecteur (26) ainsi qu'une zone de cristal (28), et orientée au moins localement le long d'un axe longitudinal (22),
- introduction du matériau d'alliage MFM fondu, en particulier du matériau d'alliage à base NiMnGa, dans la coquille de moulage, sans qu'il soit prévu un cristal de germination particulier,
- solidification du matériau d'alliage MFM par production d'un front de solidification se déplaçant depuis la zone de germination à travers la zone de sélecteur jusqu'à la zone de cristal le long d'un chemin de solidification,
dans lequel le chemin de solidification s'étend dans la zone de cristal le long de l'axe longitudinal, forme dans la zone de sélecteur une zone s'écartant de l'axe longitudinal, dont la déviation maximale, par rapport à l'axe longitudinal, est plus grande qu'une largeur maximale de section transversale dans la zone de sélecteur, et
l'axe longitudinal (22) présente un écart angulaire de moins de 10°, de préférence de moins de 6°, et de préférence encore de moins de 3°, par rapport au premier axe de cristal, et
- découpage du matériau d'alliage MFM solidifié en une multiplicité d'éléments d'actionneur MFM par des coupes perpendiculairement à l'axe longitudinal.

2. Procédé selon la revendication 1, **caractérisé en ce que** le chemin de solidification forme dans la zone de sélecteur une zone déviée en forme de dent avec deux parties angulaires, dont les côtés d'entrée et de sortie sont de préférence orientés en alignement avec l'axe longitudinal.

3. Procédé selon la revendication 1, **caractérisé en ce que** le front de solidification forme dans la zone de sélecteur une zone en forme d'hélice ou de zigzag.

4. Procédé selon l'une quelconque des revendications 1 à 3, **caractérisé en ce que** l'axe longitudinal est orienté verticalement vers un dispositif de refroidissement plan, en particulier une plaque de refroidissement, associé à la zone de germination.

5. Procédé selon l'une quelconque des revendications 1 à 4, **caractérisé en ce que** la zone de cristal s'étendant de façon allongée le long de l'axe longitudinal présente une section transversale utile pour le front de solidification de > 3 cm², en particulier de > 7 cm², et plus particulièrement encore plus grande que 12 cm².

6. Procédé selon l'une quelconque des revendications 1 à 5, **caractérisé en ce que** l'on refroidit le matériau d'alliage MFM pour produire le front de solidification d'une manière telle qu'un gradient de température apparaissant dans la zone de sélecteur dans le bain fondu, à proximité du front de solidification, vaille entre 0,3 K/mm et 20 K/mm, en particulier entre 1 K/mm et 15 K/mm.

7. Procédé selon l'une quelconque des revendications 1 à 6, **caractérisé en ce que** l'on traite le matériau d'alliage MFM pour produire le front de solidification d'une manière telle, notamment par l'action d'une vitesse relative entre la coquille de moulage et le gradient de température, que le front de solidification dans la zone de sélecteur se déplace avec une vitesse comprise entre 0,1 mm/min et 50 mm/min, en particulier entre 0,3 mm/min et 5 mm/min, le long du chemin de solidification.

8. Procédé selon l'une quelconque des revendications 1 à 7, **caractérisé en ce que** le front de solidification se déplace le long du chemin de solidification à travers une zone de sélecteur et/ou une zone de cristal de section transversale au moins localement rectangulaire, en particulier carrée.

9. Procédé selon la revendication 8, **caractérisé en ce qu'**un contour intérieur rectangulaire de section transversale de la zone de cristal détermine une orientation cristalline du matériau d'alliage MFM mono-cristallin solidifié suivant un deuxième axe de cristal orthogonal au premier axe de cristal.

10. Procédé selon l'une quelconque des revendications 1 à 9, **caractérisé en ce que** le matériau d'alliage comprend du Ni, Mn, Ga ainsi qu'au moins du Co dans la composition NiₐMn_{b}Ga_{c}CO_{d}Fe,Cu_{f}, dans laquelle a, b, c, d, e et f sont indiqués en % atomiques et satisfont les conditions
44 ≤ a ≤ 51;
19 ≤ b ≤ 30;
18 ≤ c ≤ 24;
0,1 ≤ d ≤ 15;
0 ≤ e ≤ 14,9;
0 ≤ f ≤ 14,9;
d+e+f ≤ 15;
a+b+c+d+e+f = 100.

11. Procédé selon l'une quelconque des revendications 1 à 10, **caractérisé en ce que** la solidification du matériau d'alliage MFM est opérée le long d'une multiplicité de chemins de solidification voisins l'un de l'autre et séparés l'un de l'autre.

12. Procédé selon l'une quelconque des revendications 1 à 11, **caractérisé par** la division du matériau d'alliage MFM solidifié dans la zone de cristal en ladite multiplicité d'éléments d'actionneur MFM sans détermination par une mesure technique préalable d'une orientation cristalline dans le matériau d'alliage MFM solidifié.
